# DEMANDE DE BREVET EUROPEEN

(11) **EP 0 793 336 A1**
(43) Date de publication de la demande: **03.09.1997**
(21) Numéro de dépôt: 97410025.7
(22) Date de dépôt: 25.02.1997
(51) Int. Cl.: H02P 7/295, H02P 7/00

(54) **Commande d'arrêt/marche d'un moteur bidirectionnel**

(30) Priorité: 27.02.1996 FR 9602700
(71) Demandeur: SGS-THOMSON MICROELECTRONICS S.A., 94250 Gentilly (FR)
(72) Inventeur: Pezzani, Robert, Parçay-Meslay, 37210 Vouvray (FR)
(74) Mandataire: de Beaumont, Michel

(57) **Abrégé**

L'invention concerne un composant de commutation en arrêt/marche d'un moteur (M1) alimenté selon une première ou seconde polarité, disposé en série avec ledit moteur, comprenant deux thyristors à gâchette de cathode (Th11, Th12) tête-bêche, et deux diodes de même polarité (D11, D12) dont une première borne de même polarité est respectivement connectée à chacune des gâchettes et dont les deuxièmes bornes sont reliées ensemble à une borne de commande (41).

## Description

La présente invention concerne la commande d'arrêt/marche d'un moteur bidirectionnel.

Dans de nombreux systèmes, par exemple dans une automobile, on trouve un grand nombre de moteurs dont chacun peut être alimenté par un courant continu de l'une ou l'autre polarité pour provoquer sa rotation dans l'une ou l'autre direction. C'est par exemple le cas des lève-vitres de voiture dont tous les moteurs sont connectés à la batterie par l'intermédiaire d'un inverseur permettant de relier chaque moteur selon l'une ou l'autre pola-rité, un commutateur étant associé à chaque moteur pour permettre la mise en route d'un seul moteur ou de plusieurs moteurs simultanément. Des systèmes semblables sont prévus pour la fermeture des portières et autres serrures d'une voiture, par exemple le bouchon d'essence, pour des systèmes de réglage de rétroviseur, etc. Bien que les exemples ci-dessus soient donnés dans le cas d'une application automobile, on rencontre des problèmes similaires dans d'autres domaines techniques.

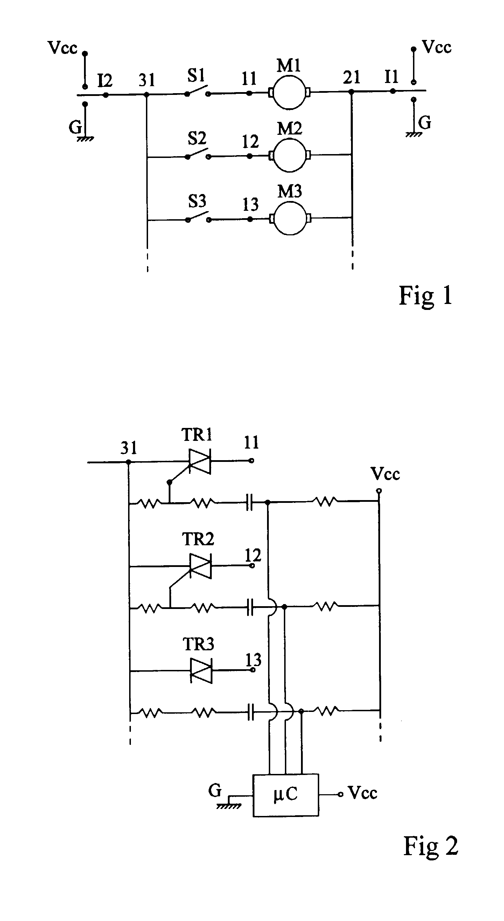

La figure 1 est un schéma simplifié illustrant le système visé. Dans ce système, on trouve plusieurs moteurs M1, M2, M3... respectivement connectés par une première borne 11, 12, 13... aux premières bornes d'interrupteurs respectifs S1, S2, S3... Les deuxièmes bornes 21 des moteurs sont communes et reliées à la borne commune d'un premier élément inverseur I1. Les deuxièmes bornes des commutateurs S1, S2, S3 sont communes et reliées à la borne commune 31 d'un élément inverseur I2. Les éléments inverseurs I1 et I2 peuvent établir des connexions respectives à une tension d'alimentation, couramnent une tension de batterie, et à la masse G, et inversement. Ainsi, un courant est susceptible de circuler dans chacun des moteurs selon l'une ou l'autre polarité selon le positionnement de l'ensemble inverseur I1-I2. Une fois choisi le sens du courant susceptible de circuler dans les moteurs, un ou plusieurs des moteurs sont alimentés selon qu'un ou plusieurs des interrupteurs S1, S2, S3... sont fermés. On peut ainsi, par exemple, réaliser au choix une commande individuelle ou une commande groupée des vitres d'une voiture.

Classiquement, les interrupteurs S1, S2, S3 sont des commutateurs électromécaniques.

Si l'on veut remplacer ces commutateurs électromécaniques par des composants statiques, la première idée qui vient à l'esprit, étant donné que ces commutateurs doivent pouvoir laisser passer un courant dans l'une ou l'autre direction est, comme le représente la figure 2, d'utiliser des triacs TR1, TR2, TR3...

Un premier inconvénient lié à l'utilisation de triacs réside dans leur commande car la borne commune 31 est ou bien à la masse ou bien à la tension Vcc. Si l'on veut commander les triacs par un microoentrôleur µC connecté entre la tension Vcc et la masse G, ce microcontrôleur va fournir des signaux de commande référencés à la masse. Lorsque la borne commune 31 est au potentiel de la masse, le microcontrôleur peut commander le triac désiré sans difficultés. Lorsque la borne 31 est au potentiel Vcc, un problème se pose car le signal de commande ne peut pas s'écouler simplement entre la sortie du microcontrôleur proche du potentiel de la masse et la borne 31 proche de la tension Vcc. Cela implique que soit mis entre la sortie du microcontrôleur et les gâchettes des triacs un circuit ou des composants permettant une adaptation du signal de commande. La figure 2 illustre une configuration possible de circuit passif d'adaptation comportant trois résistances et un condensateur. Le condensateur assure un isolement entre la tension sur la borne 31 et le microcontrôleur tout en permettant la transmission de signaux de commande impul-sionnels. On peut imaginer d'autres schémas basés sur des composants actifs (transistors bipolaires). Toutefois, en tout cas, cette commande n'est pas directe et exige une interface d'adaptation à la tension de la borne 31.

Un deuxième inconvénient des triacs est qu'ils nécessitent un courant de gâchette relativement important et ne peuvent par exemple pas être commandés directement par les sorties d'un circuit logique ou contrôleur.

Un troisième inconvénient est que les divers triacs TR1, TR2, TR3... sont nécessairement réalisés sur des puces de silicium distinctes car on ne connaît pas aujourd'hui de moyens pour intégrer sur une même puce des triacs ayant une première électrode commune, cette électrode commune étant l'électrode à laquelle est référencée la gâchette.

Ainsi, un objet de la présente invention est de prévoir un commutateur à circulation bidirectionnelle de courant et à commande unique actionnable par des signaux logiques.

Un autre objet de la présente invention est de prévoir un tel composant dans lequel les signaux logiques peuvent être produits par un circuit intégré alimenté directement par une batterie qui alimente aussi les circuits sur lesquels agit le commutateur, sans qu'il soit nécessaire de prévoir de circuit d'adaptation ou d'interface.

Un autre objet de la présente invention est de prévoir un tel composant réalisable de façon monolithique sur une puce semiconductrice.

Un autre objet de la présente invention est de prévoir un tel composant réalisable sur une puce semiconductrice unique en association avec d'autres composants identiques présentant avec lui une borne commune.

Pour atteindre ces objets, la présente invention prévoit un composant de commutation en arrêt/marche d'un moteur alimenté selon une première ou seconde polarité, disposé en série avec ledit moteur, comprenant deux thyristors à gâchette de cathode tête-bêche, et deux diodes de même polarité dont une première borne de même polarité est respectivement connectée à chacune des gâchettes et dont les deuxièmes bornes sont reliées ensemble à une borne de commande.

La présente invention prévoit aussi un système de commande en arrêt/marche d'un ensemble de moteurs respectivement reliés en série par une première borne à une première borne d'un composant de commutation selon l'invention, la deuxième borne de chaque composant de commutation et la deuxième borne de chaque moteur pouvant respectivement être reliées à une première ou une deuxième borne d'une alimentation, chaque borne de commande d'un composant étant reliée à une sortie logique d'un contrôleur.

Selon un mode de réalisation de la présente invention, le composant de commutation est réalisé sous forme monolithique et les deux thyristors sont réalisés verticalement dans un caisson d'une plaquette semiconductrice d'un premier type de conductivité délimité par un mur d'isolement du deuxième type de conductivité, la cathode du premier thyristor étant du côté supérieur du caisson, la cathode du deuxième thyristor étant du côté inférieur du caisson, la région de gâchette de cathode du deuxième thyristor étant connectée du côté supérieur par l'intermédiaire du mur d'isolement.

Selon un mode de réalisation de la présente invention, le composant de commutation est réalisé sous forme monolithique et comprend, dans un caisson d'une plaquette semiconductrice d'un premier type de conductivité délimité par un mur d'isolement du deuxième type de conductivité : du côté de la surface supérieure, des première, deuxième et troisième régions du deuxième type de conductivité ; du côté de la face arrière, une couche du deuxième type de conductivité ; des quatrième, cinquième et sixième régions du premier type de conductivité respectivement formées dans lesdites première, deuxième et troisième régions ; une septième région du premier type de conductivité, formée dans la couche de face arrière et disposée en face de la partie de la première région ne contenant pas la quatrième région ; une huitième région du premier type de conductivité prolongeant la septième région jusqu'à la zone située en regard du mur d'isolement ; une première métallisation recouvrant la face arrière ; une deuxième métallisation recouvrant les première et quatrième régions ; une troisième métallisation recouvrant les deuxième et troisième régions ; une quatrième métallisation reliant la cinquième région à la surface supérieure du mur d'isolement ; et une cinquième métallisation reliant les première et sixième régions.

Selon un mode de réalisation de la présente invention, le composant monolithique comprend une pluralité de structures identiques disposées dans des caissons isolés pour constituer une pluralité de composants de commutation ayant une électrode principale commune.

Selon un mode de réalisation de la présente invention, les deuxième et troisième régions sont plus faiblement dopées que la première région.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 décrites précédemment sont destinées à exposer le problème posé et l'état de la technique ;
la figure 3 représente un système de commutation d'arrêt/marche de moteurs utilisant un circuit selon la présente invention ;
les figures 4A et 4B représentent une même portion du circuit de la figure 3 dans deux modes de polarisation ;
la figure 5 représente une vue en coupe d'un exemple de réalisation sous forme monolithique d'un composant selon la présente invention ; et
la figure 6 représente un exemple de vue de dessus du composant de la figure 5.

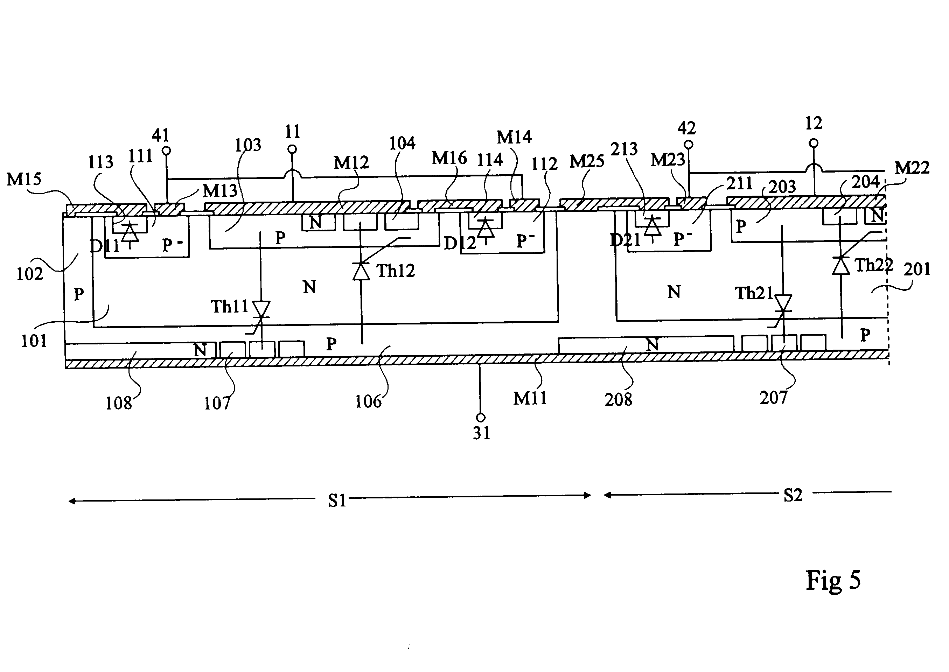

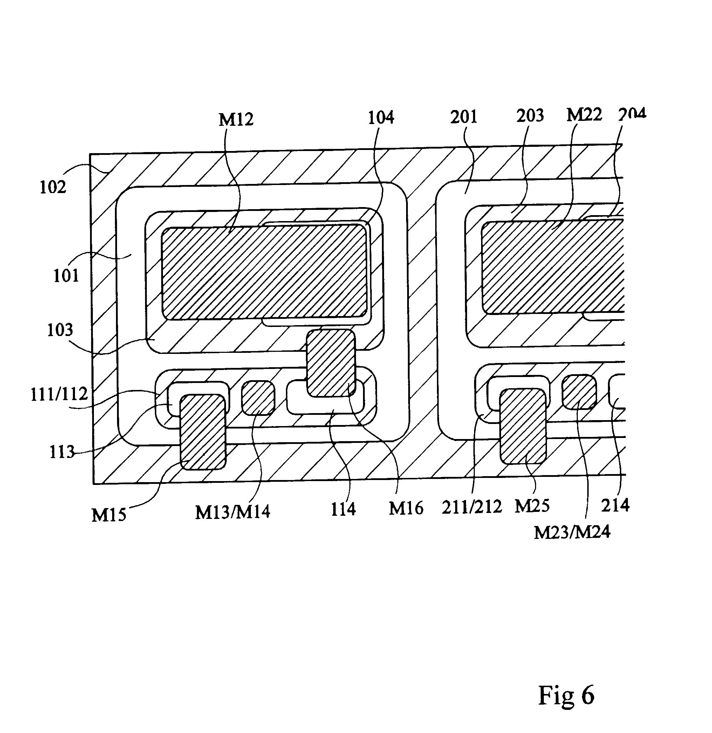

On notera que la vue en coupe de la figure 5 et la vue de dessus de la figure 6 sont extrêmement schématiques et que, conformément à l'usage dans le domaine de la représentation des composants semiconducteurs, ces figures ne sont pas tracées à l'échelle mais que les diverses dimensions tant verticales qu'horizontales sont dessinées arbitrairement pour simplifier le dessin et accroître l'intelligibilité des figures.

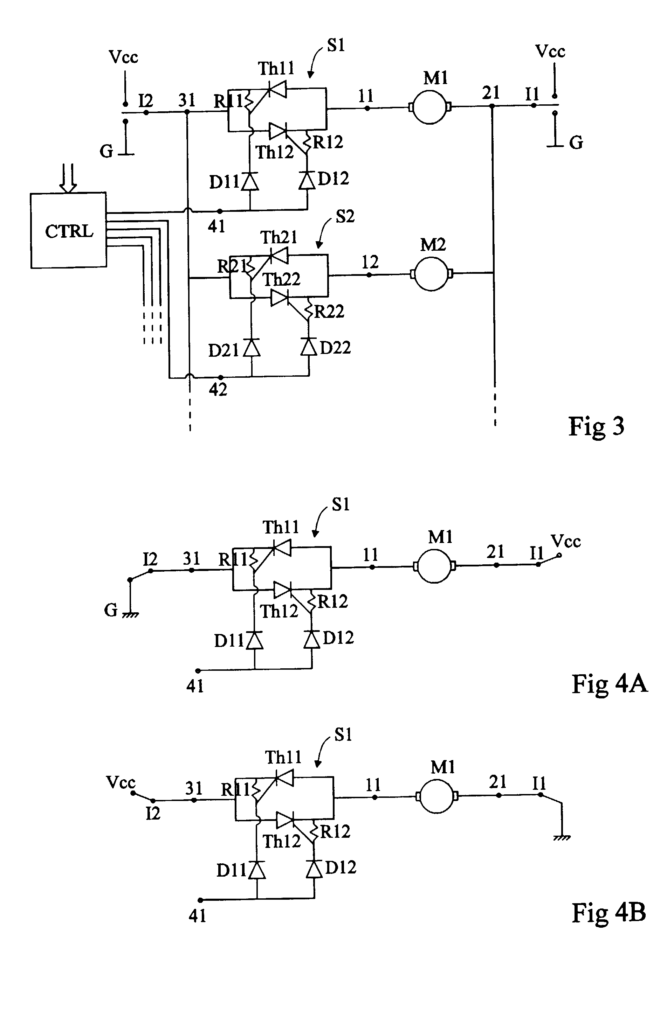

Le schéma de la figure 3 reprend celui de la figure 1 et détaille un mode de réalisation selon la présente invention des commutateurs S. Seuls deux commutateurs S1 et S2 sont représentés.

Le commutateur S1 comporte, entre les bornes 11 et 31, deux thyristors à gâchette de cathode en antiparallèle Th11 et Th12. La gâchette du thyristor Th11 est reliée à une borne de commande 41 par l'intermédiaire d'une diode D11. La gâchette du thyristor Th12 est reliée à cette même borne de commande par l'intermédiaire d'une diode D12. Ce sont les anodes des diodes D11 et D12 qui sont reliées à la borne 41.

Le commutateur S2 comporte de même des thyristors Th21, Th22 et des diodes D21, D22 dont les anodes sont reliées à une borne de commande 42.

Chacun des thyristors Th11, Th12, Th21, Th22 est associé à une résistance gâchette-cathode R11, R12, R21, R22 correspondant aux courts-circuits gâchette-cathode de ces thyristors.

Les bornes 41, 42... de chacun des commutateurs S1, S2... sont reliées à des sorties d'un circuit de commande CTRL recevant les ordres de commande d'arrêt/marche appropriés pour les divers moteurs M1, M2... Selon un aspect de la présente invention, ce circuit de commande CTRL est de préférence un microcontrôleur fournissant des signaux logiques et ses sorties sont directement reliées sans amplificateur tampon intermédiaire aux bornes de commande 41, 42...

Les figures 4A et 4B illustrent le fonctionnement du circuit selon la présente invention pour la branche associée au moteur M1.

En figure 4A, on a supposé que l'élément inverseur I1 est relié à la tension de batterie Vcc et que l'élément inverseur I2 est relié à la masse, c'est-à-dire que le commutateur S1 doit ou bien être ouvert pour éviter tout passage de courant dans le moteur M1 ou bien être fermé pour laisser passer un courant dans le moteur M1 de la borne 21 à borne 11. Pour cela, une impulsion positive est appliquée à la borne de commande 41. En conséquence, un courant de gâchette circule normalement de la borne de gâchette à la borne de cathode du thyristor Th11 vers la borne 31 et la masse. Quand on veut interrompre l'alimentation du moteur M1, on ouvre l'inverseur I1-I2.

La diode D12 a notamment pour rôle d'éviter tout renvoi de tension sur la borne 41 avant l'instant désiré de mise en conduction du thyristor Th11 par suite d'un claquage éventuel de la jonction cathode-gâchette du thyristor Th12. Cette diode doit présenter une tenue en tension suffisante pour supporter toute surtension éventuellement présente dans le circuit. De plus, en l'absence de cette diode et de la diode D11, il pourrait exister des chemins parasites d'amorçage du thyristor Th11.

La figure 4B représente la configuration dans laquelle la borne 31 est reliée à la borne Vcc et la borne 21 à la masse. Dans ce cas, l'application d'une tension positive sur la borne 41 entraîne le passage d'un courant de gâchette dans le thyristor Th12. Ce courant se referme vers la masse en traversant le moteur M1. Ceci est possible du fait que, au moment où le thyristor Th12 est commandé à la fermeture, le moteur M1 ne fonctionne pas et présente donc une très faible impédance résistive. Dès que le moteur se met en marche, une force contre-électromotrice apparaît sur la borne 11 mais le thyristor Th12 qui a initialement été mis en conduction continue à être passant tant que le courant qui le traverse n'est pas annulé par une ouverture de l'inverseur I1-I2. A nouveau, dans ce cas, la diode D11 doit être prévue pour supporter la tension inverse qui lui est appliquée. En effet, la jonction cathode-gâchette du thyristor Th11 n'est généralement pas susceptible de tenir une tension inverse élevée.

On notera que la mise en conduction du thyristor Thl2 dans la configuration de la figure 4B constitue un mode de commande non usuel d'un thyristor, le courant de gâchette étant amené à passer à travers la charge, ce qui est possible dans l'application envisagée comme cela a été exposé précédemment.

On notera que le signal de gâchette permettant l'amorçage du thyristor approprié Th11 ou Th12 est toujours du même sens positif. Ceci permet une commande directe par le contrôleur qui devra fournir un signal de sortie identique quelle que soit la polarité de la borne 31.

On a donc obtenu selon la présente invention un commutateur bidirectionnel d'arrêt-marche commandable par une borne de commande unique susceptible de recevoir un signal logique de faible puissance étant donné la sensibilité usuelle de thyristors.

La figure 5 illustre un mode de réalisation monolithique d'un composant commutateur bidirectionnel à commande unique selon la présente invention et montre également que plusieurs composants similaires présentant une borne commune peuvent être intégrés sur une même puce semiconductrice.

On a indiqué en figure 5 les bornes du composant en utilisant les références 11, 12, 31, 41 et 42 de la figure 3. Le commutateur S1 est réalisé dans une partie 101 d'un substrat de type N entouré d'un mur d'isolement 102 de type P formé par exemple par des diffusions profondes à partir des surfaces supérieure et inférieure du substrat. Dans la face supérieure du substrat est formé un caisson 103 de type P. Dans sensiblement la moitié de la surface de ce caisson est formée une région 104 de type N. Du côté de la face arrière du composant est formée une couche uniforme 106 de type P. Une région 107 de type N est formée dans la région 106 sensiblement en regard de la partie de la région 103 dans laquelle n'est pas formée la région de type N 104.

La face arrière du substrat est revêtue d'une métallisation M11 et l'ensemble des régions 103, 104 du côté de la face supérieure est revêtu d'une métallisation M12. La métallisation M11 est reliée à la borne 31 et la métallisation M12 à la borne 11. On a ainsi obtenu comme cela est illustré sur la figure 5 deux thyristors Th11 et Th12 en antiparallèle entre les métallisations M11 et M12. Le thyristor Th11 comprend de son anode à sa cathode les régions 103, 101, 106 et 107 et le thyristor Th12 comprend de son anode à sa cathode des régions 106, 101, 103 et 104. Les régions de cathode 104 et 107 des thyristors Th12 et Th11 sont classiquement munies de courts-circuits d'émetteur.

En outre, il est formé dans la partie supérieure de la région 101 des régions de type P faiblement dopées 111 et 112 contenant respectivement des régions de type N 113 et 114. La région 111 est revêtue d'une métallisation M13 et la région 112 d'une métallisation M14. Ces deux métallisations sont reliées à la borne 41. La région 113 est revêtue d'une métallisation M15 qui recouvre également la surface supérieure du mur d'isolement 102. La région 114 est revêtue d'une métallisation M16 qui est également en contact avec une portion de la surface supérieure du caisson 103 voisine de la région 104. Ainsi, la jonction entre les régions 111 et 113 correspond à la diode D11 et la jonction entre les régions 112 et 114 correspond à la diode D12. La diode D12 est directement en série entre la borne de commande 41 et la région de gâchette de cathode du thyristor Th12. La diode D11 est en série entre la borne de commande 41 et la région de gâchette de cathode du thyristor Th11 par l'intermédiaire d'un trajet vertical correspondant au mur d'isolement 102 et d'un trajet latéral correspondant à une région de la couche de type P 106 qui surmonte une région de type N 108 qui prolonge la région de type N 107.

On a marqué du symbole P⁻ les régions 111 et 112 alors que le caisson 103 est marqué du symbole P. Ceci est destiné à illustrer le fait que, de préférence, les régions 111 et 112 sont plus faiblement dopées que la région 103. En effet, les diodes D11 et D12 doivent assurer une tenue en tension satisfaisante pour éviter un claquage des jonctions de gâchette des thyristors. Dans le cas particulier où l'invention s'applique à un composant automobile et où la tension est seulement de 12 volts, on pourra éventuellement choisir pour la région 103 un niveau de dopage identique à celui des régions 111 et 112.

De façon similaire, on pourra former un autre commutateur identique, correspondant par exemple au commutateur S2 de la figure 3 dans un caisson 201 entouré d'un mur d'isolement. Ceci est représenté partiellement dans la partie droite de la figure où des éléments du commutateur S2 semblables à ceux du commutateur S1 sont désignés par les mêmes références en commençant par le chiffre 2 au lieu du chiffre 1 pour les régions semiconductrices et pour les métallisations, la métallisation de face arrière M1 étant une métallisation commune.

la figure 6 représente un exemple de vue de dessus du composant de la figure 5. Les références utilisées reprennent celles de la figure 5. Dans cette exemple, les régions 111 et 112 correspondent à une région unique et les métallisations M13 et M14 à une seule et même métallisation.

De même, d'autres variantes de réalisation apparaîtront à l'homme de l'art dans le domaine des revendications ci-après.

A titre d'exemple, pour un composant alimenté par une batterie de 12 V, on pourra choisir pour les diverses régions les concentrations en surface (Cs en atomes par cm²) et les profondeurs de jonction (xj en micromètres) suivantes :

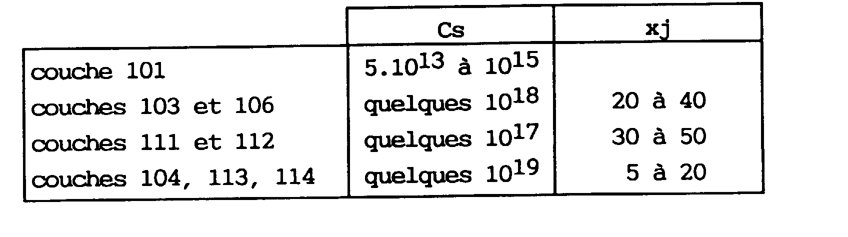

## Revendications

1. Composant de commutation en arrêt/marche d'un moteur (M1) alimenté selon une première ou seconde polarité, disposé en série avec ledit moteur, caractérisé en ce qu'il comprend :
deux thyristors à gâchette de cathode (Th11, Th12) tête-bêche, et
deux diodes de même polarité (D11, D12) dont une première borne de même polarité est respectivement connectée à chacune des gâchettes et dont les deuxièmes bornes sont reliées ensemble à une borne de commande (41).

2. Système de commande en arrêt/marche d'un ensemble de moteurs (M1, M2...) respectivement reliés en série par une première borne (11, 12, etc.) à une première borne d'un composant de commutation (S1, S2...) selon la revendication 1, la deuxième borne (31) de chaque composant de commutation et la deuxième borne (21) de chaque moteur pouvant respectivement être reliées à une première ou une deuxième borne d'une alimentation (G, Vcc), chaque borne de commande d'un composant étant reliée à une sortie logique d'un contrôleur (CTRL).

3. Composant de commutation selon la revendication 1, caractérisé en ce qu'il est réalisé sous forme monolithique et en ce que les deux thyristors sont réalisés verticalement dans un caisson (101) d'une plaquette semiconductrice d'un premier type de conductivité délimité par un mur d'isolement (102) du deuxième type de conductivité, la cathode du premier thyristor étant du côté supérieur du caisson, la cathode du deuxième thyristor étant du côté inférieur du caisson, la région de gâchette de cathode du deuxième thyristor étant connectée du côté supérieur par l'intermédiaire du mur d'isolement (102).

4. Composant de commutation selon la revendication 1, caractérisé en ce qu'il est réalisé sous forme monolithique et en ce qu'il comprend, dans un caisson (101) d'une plaquette semiconductrice d'un premier type de conductivité délimité par un mur d'isolement (102) du deuxième type de conductivité :
du côté de la surface supérieure, des première (103), deuxième (111) et troisième (112) régions du deuxième type de conductivité ;
du côté de la face arrière, une couche (106) du deuxième type de conductivité ;
des quatrième (104), cinquième (113) et sixième (114) régions du premier type de conductivité respectivement formées dans lesdites première, deuxième et troisième régions ;
une septième région (107) du premier type de conductivité, formée dans la couche (106) de face arrière et disposée en face de la partie de la première région ne contenant pas la quatrième région (104) ;
une huitième région (108) du premier type de conductivité prolongeant la septième région (107) jusqu'à la zone située en regard du mur d'isolement (102) ;
une première métallisation (M11) recouvrant la face arrière ;
une deuxième métallisation (M12) recouvrant les première et quatrième régions ;
une troisième métallisation (M13, M14) recouvrant les deuxième (111) et troisième (112) régions ;
une quatrième métallisation (M15) reliant la cinquième région (113) à la surface supérieure du mur d'isolement (102) ; et
une cinquième métallisation (M16) reliant les première (103) et sixième (114) régions.

5. Composant monolithique selon la revendication 4, caractérisé en ce qu'il comprend une pluralité de structures identiques disposées dans des caissons isolés pour constituer une pluralité de composants de commutation ayant une électrode principale commune.

6. Composant selon la revendication 4, caractérisé en ce que les deuxième et troisième régions sont plus faiblement dopées que la première région.
